# FASCICULE DE BREVET EUROPEEN

(11) **EP 3 529 834 B1**
(45) Date de publication et mention de la délivrance du brevet: **16.09.2020**
(21) Numéro de dépôt: 17792126.9
(22) Date de dépôt: 13.10.2017
(51) Int. Cl.: H01L 25/075, H01L 27/32

(54) **DISPOSITIF D'AFFICHAGE ET PROCEDE DE FABRICATION D'UN TEL DISPOSITIF**
ANZEIGEVORRICHTUNG UND VERFAHREN ZUR HERSTELLUNG SOLCH EINER VORRICHTUNG
DISPLAY DEVICE AND METHOD FOR PRODUCING SUCH A DEVICE

(30) Priorité: 21.10.2016 FR 1660225
(43) Date de publication de la demande: 28.08.2019
(73) Titulaire: Commissariat à l'énergie atomique et aux énergies alternatives, 75015 Paris (FR)
(72) Inventeur: MAINDRON, Tony, 38000 Grenoble (FR); RACINE, Benoit, 38690 Bevenais (FR); TEMPLIER, François, 38054 Grenoble Cedex 9 (FR)
(74) Mandataire: Cabinet Beaumont
(86) Numéro de dépôt international: PCT/FR2017/052824
(87) Numéro de publication internationale: WO 2018/073515

(56) Documents cités:
- WO-A1-2015/081289
- US-A- 5 583 350

## Description

La présente demande de brevet revendique la priorité de la demande de brevet français FR16/60225.

### Domaine

La présente demande concerne le domaine des dispositifs d'affichage émissifs. Elle vise plus particulièrement un dispositif d'affichage émissif monolithique comportant une pluralité de diodes électroluminescentes et un circuit électronique adapté à commander individuellement ces diodes pour afficher des images. Elle vise aussi un procédé de fabrication d'un tel dispositif. La présente demande concerne plus particulièrement le domaine des dispositifs d'affichage d'images couleur.

### Exposé de l'art antérieur

On a déjà proposé des dispositifs d'affichage comportant une pluralité de diodes électroluminescentes organiques, et un circuit de commande permettant de contrôler individuellement ces diodes pour afficher des images. Pour afficher des images couleur, de tels dispositifs peuvent comporter des diodes électroluminescentes organiques adaptées à émettre de la lumière des gammes de longueurs d'ondes distinctes.

Un inconvénient de ces dispositifs réside dans la durée de vie relativement faible des diodes électroluminescentes organiques, notamment lorsque ces dernières sont prévues pour fonctionner à des niveaux de luminance élevés, par exemple supérieurs à 10000 cd/m². En particulier, si l'on sait réaliser des diodes électroluminescentes organiques adaptées à émettre de la lumière verte ou de la lumière rouge à des niveaux de luminance élevés tout en présentant des durées de vie importantes, il est à ce jour difficile d'obtenir des diodes électroluminescentes adaptées à émettre de la lumière bleue à des niveaux de luminance élevés et présentant des durées de vie importantes.

On a par ailleurs proposé des dispositifs d'affichage comportant une pluralité de diodes électroluminescentes inorganiques au nitrure de gallium, et un circuit de commande permettant de contrôler individuellement ces diodes pour afficher des images. Les diodes électroluminescentes au nitrure de gallium sont en effet adaptées à émettre à des niveaux de luminance élevés et présentent des durées de vie importantes. Dans un tel dispositif, les diodes électroluminescentes émettent généralement toutes dans une même gamme de longueurs d'onde, typiquement de la lumière bleue. Pour pouvoir afficher des images couleurs, les diodes des pixels rouge et vert sont alors revêtues d'éléments de conversion de couleur, par exemple à base de phosphore, adaptés à convertir en lumière rouge ou en lumière verte la lumière bleue émise par les diodes.

Les documents WO 2015/081289 A1 et US 5 583 350 A décrivent des dispositifs d'affichage comprenant à la fois des diodes électroluminescentes inorganiques et organiques.

Un inconvénient de ces dispositifs réside dans les contraintes liées à la réalisation des éléments de conversion de couleur, notamment en matière d'encombrement et/ou de coût de fabrication.

Il serait souhaitable de pouvoir disposer d'un dispositif d'affichage d'images couleur palliant tout ou partie des inconvénients des dispositifs connus.

### Résumé

L'invention concerne un dispositif d'affichage et un procédé pour sa fabrication tels que définis dans les revendications 1 et 6, respectivement. Les modes de réalisation préférés sont définis dans les revendications dépendantes 2 - 5 et 7 - 12.

Ainsi, un mode de réalisation prévoit un dispositif d'affichage monolithique comprenant une pluralité de premiers pixels adaptés à émettre de la lumière dans une première gamme de longueurs d'ondes, et une pluralité de deuxièmes pixels adaptés à émettre de la lumière dans une deuxième gamme de longueurs d'ondes, les premiers pixels comportant chacun une diode électroluminescente au nitrure de gallium, et les deuxièmes pixels comportant chacun une diode électroluminescente organique.

Le dispositif comporte un circuit intégré de commande comportant, du côté d'une première face, pour chaque pixel, un plot métallique de connexion, les diodes électroluminescentes des premiers et deuxièmes pixels étant disposées du côté de la première face du circuit de commande, et la diode électroluminescente de chaque pixel comportant une première électrode connectée au plot métallique de connexion du pixel.

Dans chaque pixel, la diode électroluminescente du pixel comporte au moins une couche semiconductrice revêtant la face de la première électrode opposée au circuit de commande, et une deuxième électrode revêtant la face de ladite au moins une couche semiconductrice opposée à la première électrode.

Selon un mode de réalisation, les deuxièmes électrodes des diodes électroluminescentes des premiers et deuxièmes pixels sont interconnectées.

Les deuxièmes électrodes des premiers pixels et les premières électrodes des deuxièmes pixels sont disposées dans un même niveau conducteur du dispositif.

Selon un mode de réalisation, la couche semiconductrice des deuxièmes pixels est une couche continue commune à tous les deuxièmes pixels du dispositif et s'étendant sur sensiblement toute la surface du dispositif.

Selon un mode de réalisation, dans chaque premier pixel, la deuxième électrode du pixel est isolée de ladite au moins une couche semiconductrice des deuxièmes pixels par une couche d'isolation localisée.

Selon un mode de réalisation, la couche semiconductrice des deuxièmes pixels est une couche discontinue localisée au niveau des seules diodes électroluminescentes des deuxièmes pixels.

Un autre mode de réalisation prévoit un procédé de fabrication d'un dispositif d'affichage monolithique comprenant une pluralité de premiers pixels adaptés à émettre de la lumière dans une première gamme de longueurs d'ondes, et une pluralité de deuxièmes pixels adaptés à émettre de la lumière dans une deuxième gamme de longueurs d'ondes, ce procédé comprenant les étapes successives suivantes :
a) former un circuit intégré de commande comportant, sur une première face, pour chaque pixel du dispositif, un plot métallique de connexion ;
b) pour chaque premier pixel, rapporter sur la première face du circuit de commande un empilement actif de diode électroluminescente au nitrure de gallium comportant une première électrode en contact avec le plot métallique de connexion du pixel, et au moins une couche semiconductrice revêtant la face de la première électrode opposée au circuit de commande ;
c) combler un volume séparant latéralement les empilements actifs des diodes électroluminescentes au nitrure de gallium par un matériau de remplissage isolant ;
d) former, dans un même niveau conducteur, pour chaque premier pixel, une deuxième électrode revêtant la face de la couche semiconductrice opposée à la première électrode, et, pour chaque deuxième pixel, une première électrode revêtant le matériau de remplissage et connectée au plot métallique de connexion du pixel.

Selon un mode de réalisation, le procédé comporte en outre, après l'étape d), une étape e) de dépôt, pour chaque deuxième pixel, d'au moins une couche semiconductrice organique revêtant la face de la première électrode du pixel opposée au circuit de commande.

Selon un mode de réalisation, la couche semiconductrice organique est une couche continue commune à tous les deuxièmes pixels du dispositif et s'étendant sur sensiblement toute la surface du dispositif.

Selon un mode de réalisation, le procédé comporte en outre, entre l'étape d) et l'étape e), une étape de formation d'une couche d'isolation localisée isolant les deuxièmes électrodes des premiers pixels de la couche semiconductrice organique.

Selon un mode de réalisation, la couche semiconductrice organique est une couche discontinue localisée au niveau des seules diodes électroluminescentes des deuxièmes pixels.

Selon un mode de réalisation, le procédé comporte en outre, après l'étape e), une étape de dépôt, pour chaque deuxième pixel, d'une deuxième électrode revêtant la face de la couche semiconductrice organique opposée à la première électrode du pixel.

Selon un mode de réalisation, les deuxièmes électrodes des deuxièmes pixels forment une couche continue s'étendant sur sensiblement toute la surface du dispositif.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
les figures 1A, 1B, 1C et 1D sont des vues en coupe illustrant de façon schématique un exemple d'un mode de réalisation d'un procédé de fabrication d'un dispositif d'affichage d'images couleur ;
la figure 2 est une vue de dessus illustrant schématiquement un exemple d'un mode de réalisation d'un dispositif d'affichage d'images couleur ; et
la figure 3 est une vue en coupe illustrant de façon schématique un exemple d'un autre mode de réalisation d'un dispositif d'affichage d'images couleur.

### Description détaillée

De mêmes éléments ont été désignés par de mêmes références dans les différentes figures et, de plus, les diverses figures ne sont pas tracées à l'échelle. Par souci de clarté, seuls les éléments utiles à la compréhension des modes de réalisation décrits ont été représentés et sont détaillés. En particulier, la composition et l'agencement des différentes couches d'un empilement actif de diode électroluminescente organique, et la composition et l'agencement des différentes couches d'un empilement actif de diode électroluminescente au nitrure de gallium n'ont pas été détaillés, les modes de réalisations décrits étant compatibles avec les empilements actifs usuels de diodes électroluminescentes organiques et de diodes électroluminescentes au nitrure de gallium. De plus, la réalisation d'un circuit intégré de contrôle des diodes électroluminescentes n'a pas été détaillée, les modes de réalisation décrits étant compatibles avec les structures et procédés de fabrication usuels de tels circuits de contrôle.

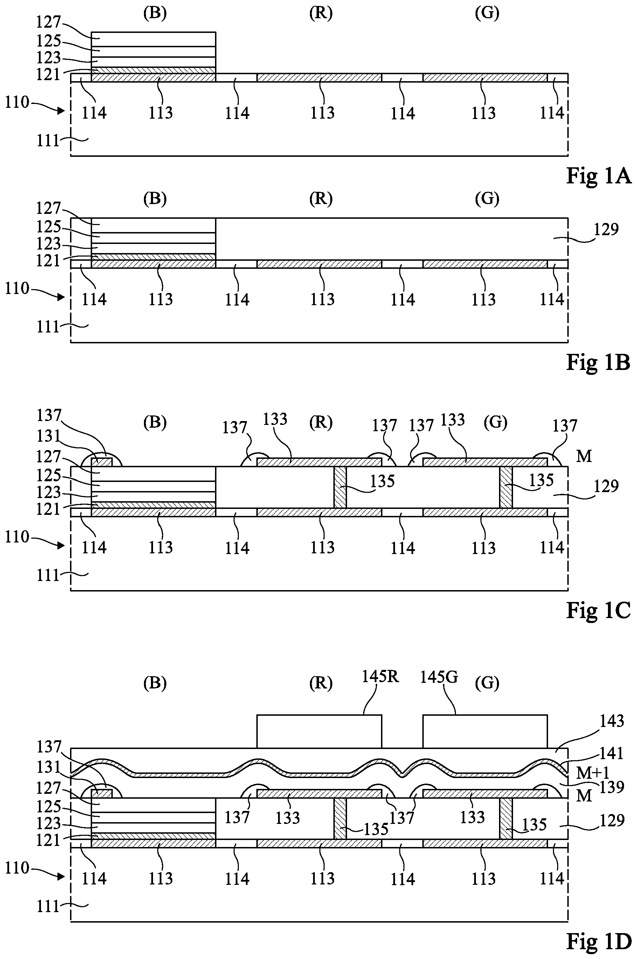

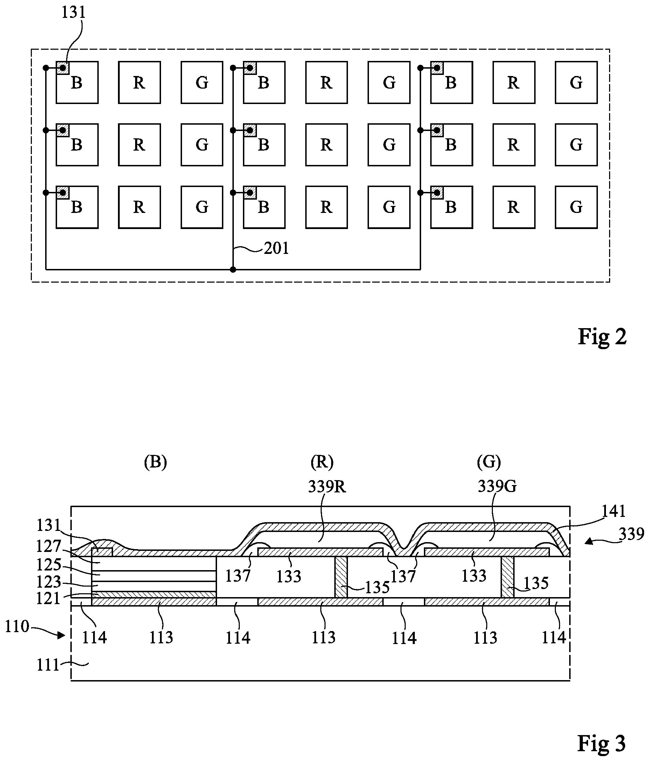

Dans la description qui suit, lorsque l'on fait référence à des qualificatifs de position absolue, tels que les termes "avant", "arrière", etc., ou relative, tels que les termes "dessus", "dessous", "supérieur", "inférieur", etc., ou à des qualificatifs d'orientation, tels que les termes "horizontal", "vertical", etc., il est fait référence à l'orientation des vues en coupe des figures 1A, 1B, 1C, 1D ou 3, étant entendu que, en pratique, les dispositifs décrits peuvent être orientés différemment. Sauf précision contraire, les expressions "approximativement", "sensiblement", et "de l'ordre de" signifient à 10 % près, de préférence à 5 % près.

Selon un aspect d'un mode de réalisation, on prévoit, dans un dispositif d'affichage d'images couleur monolithique, de co-intégrer des diodes électroluminescentes inorganiques au nitrure de gallium adaptées à émettre de la lumière dans une première gamme de longueurs d'ondes, par exemple de la lumière bleue (c'est-à-dire de longueur d'onde comprise entre 450 et 490 nm), et des diodes électroluminescentes organiques adaptées à émettre de la lumière dans une ou plusieurs autres gammes de longueurs d'ondes, par exemple de la lumière verte (c'est-à-dire de longueur d'onde comprise entre 490 et 570 nm) et de la lumière rouge (c'est-à-dire de longueur d'onde comprise entre 600 et 700 nm) .

Les figures 1A, 1B, 1C et 1D sont des vues en coupe illustrant de façon schématique des étapes successives d'un exemple d'un mode de réalisation d'un procédé de fabrication d'un tel dispositif. Les figures 1A, 1B, 1C et 1D représentent plus particulièrement la réalisation de trois pixels B, R et G du dispositif, comprenant chacun une diode électroluminescente, et étant adaptés à émettre de la lumière respectivement dans trois bandes de longueurs d'ondes distinctes. A titre d'exemple, les pixels B, R et G sont adaptés à émettre respectivement de la lumière bleue, de la lumière rouge et de la lumière verte. En pratique, le dispositif d'affichage peut comporter une pluralité de pixels B identiques ou similaires, une pluralité de pixels R identiques ou similaires, et une pluralité de pixels G identiques ou similaires, les pixels de chaque type B, R et G pouvant être régulièrement répartis sur sensiblement toute la surface du dispositif, par exemple selon un agencement matriciel.

La figure 1A représente de façon schématique un circuit intégré de commande 110, préalablement formé dans et sur un substrat semiconducteur 111, par exemple un substrat en silicium. Dans cet exemple, le circuit de commande 110 comprend, du côté de sa face supérieure, pour chaque pixel B, R et G du dispositif, un plot métallique de connexion 113 destiné à être connecté à l'une des électrodes (d'anode ou de cathode) de la diode électroluminescente du pixel, de façon à pouvoir commander un courant circulant dans la diode et/ou une tension appliquée à la diode. Le circuit de contrôle comprend par exemple, pour chaque pixel, connecté au plot métallique 113 du pixel, une cellule élémentaire de contrôle comportant un ou plusieurs transistors, permettant de contrôler le courant et/ou la tension appliqués à la diode du pixel. Le circuit de commande 110 est par exemple réalisé en technologie CMOS. Les plots métalliques 113 peuvent être latéralement entourés par un matériau isolant 114, par exemple de l'oxyde de silicium, de façon que le circuit de commande 110 présente une surface supérieure sensiblement plane comprenant une alternance de plots métalliques 113 et de régions isolantes 114. Comme cela sera expliqué plus en détail ci-après, le contact sur les autres électrodes (non connectées aux plots 113) des diodes électroluminescentes, peut être pris de façon collective, par exemple dans une région périphérique du circuit de commande 110, par l'intermédiaire d'un ou plusieurs plots de connexion (non visibles sur les figures) du circuit de commande 110.

La figure 1A illustre plus particulièrement une étape de report, sur chaque plot de connexion 113 d'un pixel B du dispositif, d'un empilement actif de diode électroluminescente au nitrure de gallium. Dans cet exemple, l'empilement actif rapporté sur le circuit de commande est un empilement vertical comprenant, dans l'ordre à partir de la surface du plot de connexion 113, une couche conductrice 121, par exemple métallique, une couche de nitrure de gallium dopé de type P 123, une couche émissive 125, et une couche de nitrure de gallium dopé de type N 127. La couche émissive 125 est par exemple constituée par un empilement d'une ou plusieurs couches émissives formant chacune un puit quantique, par exemple à base de GaN, InN, InGaN, AlGaN, AlN, AlInGaN, GaP, AlGaP, AlInGaP, ou d'une combinaison d'un ou plusieurs de ces matériaux. A titre de variante, la couche émissive 125 peut être une couche de nitrure de gallium intrinsèque, c'est-à-dire non intentionnellement dopée, par exemple de concentration en donneurs résiduels comprise entre 10¹⁵ et 10¹⁸ atomes/cm³, par exemple de l'ordre de 10¹⁷ atomes/cm³. Dans cet exemple, la face supérieure de la couche émissive 125 est en contact avec la face inférieure de la couche 127, la face inférieure de la couche émissive 125 est en contact avec la face supérieure de la couche 123, la face inférieure de la couche 123 est en contact avec la face supérieure de la couche 121, et la face inférieure de la couche 121 est en contact avec la face supérieure du plot 113. La couche conductrice 121 forme l'électrode d'anode de la diode du pixel B, les couches 123 et 127 formant respectivement les régions semiconductrices d'anode et de cathode de la diode. A titre de variante, l'empilement rapporté sur le circuit de commande 110 peut ne pas comporter la couche conductrice 121, auquel cas la couche semiconductrice 123 de l'empilement vient directement au contact du plot métallique 113 du circuit de commande, le plot 113 constituant alors l'électrode d'anode de la diode du pixel B.

Dans l'exemple représenté, l'empilement rapporté sur le circuit de commande 110 à l'étape de la figure 1A ne comprend pas l'électrode supérieure de la diode du pixel B (son électrode de cathode dans cet exemple), c'est-à-dire l'électrode revêtant la face de la couche 127 opposée à la couche 123. Cette électrode supérieure sera en effet déposée lors d'une étape ultérieure, en même temps que les électrodes inférieures des diodes électroluminescentes des pixels R et G.

L'empilement de diode au nitrure de gallium rapporté sur le circuit de commande 110 à l'étape de la figure 1A peut être préalablement formé par épitaxie sur un substrat de support adapté, par exemple un substrat en saphir ou en corindon (non représenté). Plus particulièrement, les couches 127, 125 et 123 peuvent être successivement formées par épitaxie à partir d'une face du substrat de support, puis la couche 121 peut, le cas échéant, être déposée sur la face de la couche 123 opposée au substrat de support. Le substrat de support peut ensuite être retiré, puis les diodes peuvent être individualisées, par exemple par sciage. Pour réaliser la découpe des diodes en puces individuelles, un film adhésif de maintien peut au préalable être disposé du côté de la face de l'empilement actif opposée au substrat de support. Une fois les diodes individualisées, ces dernières peuvent être rapportées une par une sur le circuit de contrôle 110, pour obtenir la structure de la figure 1A.

A titre de variante, l'empilement actif peut être rapporté d'un seul tenant sur la face supérieure du circuit de contrôle 110, avant découpe de l'empilement en diodes individuelles, de façon à ce que l'empilement recouvre sensiblement toute la surface du circuit de contrôle 110. Le substrat de support de l'empilement actif peut ensuite être retiré, par exemple par meulage, puis l'empilement actif peut être localement retiré par gravure en regard des pixels R et G, pour ne conserver des portions de l'empilement actif qu'au-dessus des pixels B du capteur, de façon à obtenir la structure de la figure 1A.

A l'issue de l'étape de la figure 1A, les parties actives des diodes électroluminescentes des pixels B forment des plots ou îlots disjoints disposés sur la face supérieure du circuit de commande 110. Ces plots ou îlots ont par exemple une épaisseur comprise entre 0,1 et 1 µm, par exemple de l'ordre de 0,5 µm.

La figure 1B illustre une étape de planarisation de la surface supérieure de la structure obtenue à l'issue de l'étape de la figure 1A. Lors de cette étape, le volume séparant latéralement les parties actives des diodes des pixels B est comblé par un matériau de remplissage isolant 129, par exemple de l'oxyde de silicium ou de la résine, de façon à obtenir une structure présentant une surface supérieure sensiblement plane. A titre d'exemple, le matériau de remplissage 129 est d'abord déposé sur toute la surface supérieure de la structure, y compris au-dessus des pixels B, sur une épaisseur supérieure à celle des empilements actifs de diodes des pixels B, puis une étape de planarisation est mise en oeuvre, par exemple par polissage mécano-chimique, au cours de laquelle le matériau de remplissage n'est conservé qu'autour des empilements actifs des diodes des pixels B, sur une épaisseur sensiblement égale à celle des empilements actifs.

La figure 1C illustre une étape de formation simultanée, dans un même niveau conducteur M, par exemple métallique, d'électrodes supérieures 131 des diodes inorganiques des pixels B du dispositif, et d'électrodes inférieures 133 des diodes organiques des pixels R et G du dispositif. Par niveau conducteur, on entend ici un ensemble de régions conductrices formées simultanément et disposées dans un même plan moyen sensiblement parallèle à la face supérieure du circuit de commande 110.

Plus particulièrement, lors de cette étape, on forme, sur chaque pixel B du dispositif, une électrode de cathode 131 disposée sur et en contact avec la face supérieure de la couche de cathode 127 de la diode du pixel. Dans cet exemple, l'électrode 131 ne recouvre qu'une partie de la surface supérieure de la diode du pixel B. En effet, le dispositif décrit en relation avec les figures 1A, 1B, 1C et 1D est destiné à émettre de la lumière par sa face supérieure, et l'électrode 131 ne doit donc pas masquer la totalité de la surface supérieure de la diode du pixel B. A titre d'exemple, l'électrode 131 s'étend, en vue de dessus, sur toute ou partie d'une région périphérique de la diode du pixel B.

Lors de cette étape, on forme en outre, sur chaque pixel R et sur chaque pixel G du dispositif, une électrode 133 disposée sur la face supérieure de la couche isolante de remplissage 129, par exemple à l'aplomb du plot de connexion 113 du pixel. L'électrode 133 s'étend par exemple sur toute la surface de la diode électroluminescente organique (non encore réalisée) du pixel. L'électrode 133 est connectée au plot de connexion sous-jacent 113 du pixel par l'intermédiaire d'un via conducteur 135, par exemple en tungstène ou en cuivre, traversant la couche isolante 129. Les vias 135 peuvent être réalisés après le dépôt de la couche isolante 129 et avant la formation des électrodes 131 et 133, lors d'une étape non détaillée. On notera que le plot 113 a pour fonction d'alimenter électriquement l'électrode 133 par le bais du via 135. Ainsi, à titre de variante, le plot 113 peut avoir une surface inférieure ou supérieure à celle de l'électrode 133, et/ou être décalé (en vue de dessus) par rapport à l'électrode 133.

De préférence, les électrodes 133 (et par conséquent les électrodes 131, ces dernières étant réalisées dans le même niveau conducteur M que les électrodes 133), sont prévues pour avoir une face supérieure réfléchissante pour la lumière en provenance de la partie supérieure du dispositif. Ceci permet d'accroître le rendement lumineux du dispositif en renvoyant vers sa face supérieure la lumière émise par les couches électroluminescentes organiques en direction de sa face inférieure. A titre d'exemple, les électrodes 133 comprennent au moins une couche supérieure en argent, en oxyde d'étain, en aluminium, en un alliage aluminium-cuivre, ou en un oxyde conducteur transparent (ZnO, AZO, ITO, etc.).

Les vias 135 et les électrodes 131 et 133 peuvent être réalisés selon des procédés classiques de photolithographie du type habituellement utilisés pour la fabrication de circuits intégrés, par exemple en technologie CMOS.

La figure 1C illustre en outre une étape postérieure à la formation des électrodes 131 et 133, au cours de laquelle une couche d'isolation localisée 137, par exemple en résine, est déposée sur toute la surface supérieure et sur les flancs des métallisations 131, de façon à isoler les métallisations 131 des couches supérieures (non visibles sur la figure 1C) du dispositif. La couche d'isolation 137 ne s'étend en revanche pas sur au moins une partie de la face supérieure des électrodes inférieures 133 des diodes des pixels R et G. Dans l'exemple représenté, la couche d'isolation 137 s'étend sur une région périphérique et sur les flancs de chaque électrode 133, de façon à renforcer l'isolation entre les diodes de pixels voisins du dispositif, et de façon à adoucir les arêtes formées par les électrodes 133 en vue du dépôt ultérieur d'une couche semiconductrice organique. La couche d'isolation localisée 137 est par exemple en une résine photosensible. La résine est par exemple dans un premier temps étalée sur toute la surface supérieure du dispositif, puis insolée et gravée de façon à ne conserver la résine que dans les régions souhaitées.

La figure 1D illustre une étape de dépôt d'une couche semiconductrice organique 139 sur la surface supérieure de la structure obtenue à l'issue de la suite d'étapes de la figure 1C. La couche 139 est une couche active de diode électroluminescente organique. La couche 139 peut être une couche unique en un mélange de matériaux semiconducteurs organiques de types de conductivité opposés, ou un empilement vertical d'au moins deux couches de matériaux semiconducteurs organiques de types de conductivité opposés. Plus généralement, tout empilement d'une ou plusieurs couches semiconductrices organiques adapté à émettre de la lumière lorsqu'il est traversé par un courant peut être utilisé. Dans cet exemple, la couche semiconductrice organique 139 est choisie adaptée à émettre simultanément de la lumière verte et de la lumière rouge. A titre de variante, la couche semiconductrice organique 139 est choisie adaptée à émettre de la lumière blanche, c'est-à-dire adaptée à émettre simultanément de la lumière bleue, de la lumière verte et de la lumière rouge. La couche semiconductrice organique 139 s'étend de façon continue sur sensiblement toute la surface supérieure de la structure obtenue à l'issue de la suite d'étapes de la figure 1C. En particulier, la couche semiconductrice organique 139 a sa face inférieure en contact électrique avec les électrodes inférieures 133 des pixels R et G du dispositif. La couche d'isolation localisée 137 permet en revanche que la couche semiconductrice organique 139 ne soit pas en contact électrique avec les électrodes supérieures 131 des pixels B du dispositif. On notera que selon les matériaux choisis pour former les électrodes 133 et la couche organique 139, une ou plusieurs couches conductrices d'adaptation peuvent être déposées sur la surface supérieure de la structure obtenue à l'issue de la suite d'étapes de la figure 1C, avant le dépôt de la couche semiconductrice organique 139.

La figure 1D illustre en outre une étape de dépôt, sur la surface supérieure de la couche semiconductrice organique 139, d'une couche conductrice 141 correspondant à l'électrode supérieure des pixels R et G du dispositif. La couche 141 est formée dans un niveau conducteur M+1 situé au-dessus du niveau M. La couche conductrice 141 forme une électrode commune à tous les pixels R et G du dispositif. Dans cet exemple, la couche 141 est une couche continue s'étendant sur sensiblement toute la surface supérieure du dispositif. Le dispositif étant destiné à être visualisé du côté de sa face supérieure, la couche d'électrode supérieure 141 est choisie apte à transmettre la majeure partie de la lumière émise par les diodes électroluminescentes organiques des pixels R et G, et par les diodes électroluminescentes inorganiques des pixels B. A titre d'exemple, l'électrode 141 est une électrode métallique, par exemple en argent, d'épaisseur inférieure à 10 nm, ou une électrode en un matériau conducteur transparent, par exemple en oxyde d'indium étain. En pratique, selon les matériaux choisis pour former la couche semiconductrice organique 139 et l'électrode supérieure 141, une ou plusieurs couches conductrices d'adaptation peuvent être déposées sur la surface supérieure de la couche 139, avant le dépôt de la couche conductrice 141.

La figure 1D illustre en outre une étape de dépôt, sur la surface supérieure de la couche conductrice 141, d'une couche d'encapsulation 143, ayant notamment pour fonction de prévenir des pénétrations d'air ou d'humidité dans la couche semiconductrice organique 139. A titre d'exemple, la couche d'encapsulation 143 est déposé par dépôt ALD (de l'anglais "Atomic Layer Déposition" - dépôt en couches monoatomiques). La couche 143 est par exemple en oxyde de silicium (SiO₂) ou en oxyde d'aluminium (Al₂O₃).

La figure 1D illustre de plus une étape de dépôt, au-dessus de la diode électroluminescente organique de chaque pixel R, respectivement G, d'un filtre couleur 145R, respectivement 145G, par exemple en résine colorée. Le filtre 145R transmet uniquement une première partie du spectre de la lumière émise par la diode électroluminescente sous-jacente, et le filtre 145G transmet uniquement une deuxième partie (distincte de la première partie) du spectre de la lumière émise par la diode électroluminescente sous-jacente. Dans cet exemple, le filtre 145R transmet uniquement de la lumière rouge et le filtre 145G transmet uniquement de la lumière verte. A titre de variante, dans chaque pixel B, la diode électroluminescente inorganique est en outre surmontée d'un filtre couleur (non représenté), par exemple en résine colorée, présentant une bande passante distincte de celles des filtres 145R et 145G, par exemple un filtre adapté à transmettre uniquement de la lumière bleue. La prévision d'un filtre sur les pixels B permet par exemple de corriger une éventuelle dispersion en longueur d'onde de la lumière émise par la diode électroluminescente inorganique du pixel, induite par la couche semiconductrice organique 139. La prévision d'un filtre spécifique sur les pixels B peut en outre permettre de compenser une éventuelle différence de luminosité entre les diodes électroluminescentes inorganiques des pixels B et les diodes électroluminescentes organiques des pixels R et G. En effet, les cellules élémentaires de contrôle du circuit de commande 110 sont de préférence toutes identiques afin de simplifier la réalisation du circuit 110. Dans ce cas, les diodes des pixels B, R et G reçoivent sensiblement la même tension d'alimentation. Dans le cas où, pour une même tension d'alimentation, les diodes électroluminescentes inorganiques des pixels B émettent à un niveau de luminance plus élevé que les diodes électroluminescentes organiques des pixels R et G, la prévision d'un filtre couleur sur les pixels B peut permettre d'atténuer le niveau de luminance des pixels B pour le ramener à un niveau équivalent à celui des pixels R et G.

Ainsi, le dispositif obtenu à l'issue de la suite d'étapes de la figure 1D comprend des pixels B, R et G adaptés à émettre de la lumière respectivement dans trois bandes de longueurs d'ondes distinctes, chaque pixel B comprenant une diode électroluminescente inorganique et chaque pixel R ou G comprenant une diode électroluminescente organique.

Dans cet exemple, les électrodes inférieures 133 des diodes électroluminescentes des pixels R et G correspondent aux électrodes d'anode des diodes électroluminescentes organiques, et l'électrode supérieure 141 correspond à l'électrode de cathode des diodes électroluminescentes organiques.

La figure 2 est une vue de dessus illustrant schématiquement un exemple d'agencement des pixels B, R et G du dispositif de la figure 1D. Sur la figure 2, les pixels sont schématisés par des carrés. De plus, sur chaque pixel B, l'électrode supérieure 131 de la diode du pixel est représentée par un carré hachuré. On a aussi représenté sur la figure 2, par un rectangle en trait interrompu, l'électrode supérieure 141 des diodes des pixels R et G. En vue de dessus, les pixels B, R et G sont par exemple disposés en matrice selon des lignes et des colonnes.

Les électrodes supérieures 131 des pixels B du dispositif sont connectées les unes aux autres par l'intermédiaire d'un réseau de pistes conductrices 201 (non visibles sur les figures 1A, 1B, 1C, 1D) réalisé dans le niveau conducteur M en même temps que les électrodes 131 et 133. La couche d'isolation 137 (figures 1C et 1D) recouvrant les électrodes supérieures 131 des pixels B recouvre en outre la surface supérieure et les flancs des pistes conductrices 201, de façon à isoler le réseau de pistes conductrices 201 de la couche semiconductrice organique 139 (figure 1D) du dispositif.

Le réseau 201 de pistes conductrices d'interconnexion des électrodes 131 est connecté, à l'extérieur de la matrice de pixels, par exemple en périphérie de la matrice de pixels, à l'électrode supérieure 141 commune aux diodes électroluminescente organiques des pixels R et G. Ceci permet d'interconnecter les électrodes supérieures de toutes les diodes électroluminescentes du dispositif, la commande individuelle de chaque diode étant réalisée par son électrode inférieure 121 ou 133, par l'intermédiaire du plot de connexion 113 correspondant du circuit de commande 110.

On notera que dans l'exemple décrit ci-dessus, seule la couche d'électrode inférieure 133 des diodes électroluminescentes organiques est pixellisée, la couche semiconductrice organique 139 et la couche d'électrode supérieure 141 étant des couches continues.

La figure 3 est une vue en coupe illustrant de façon schématique un exemple d'un autre mode de réalisation d'un dispositif d'affichage d'images couleur.

Le dispositif de la figure 3 diffère du dispositif décrit ci-dessus principalement en ce que, dans le dispositif de la figure 3, la couche semiconductrice organique continue 139 du dispositif décrit précédemment est remplacée par une couche semiconductrice organique 339 discontinue, localisée uniquement au niveau des diodes électroluminescentes organiques des pixels R et G du dispositif.

La réalisation du dispositif de la figure 3 comprend par exemple les mêmes étapes que celles décrites en relation avec les figures 1A, 1B et 1C.

La réalisation du dispositif de la figure 3 comprend en outre une étape de dépôt d'une couche semiconductrice organique 339 sur la surface supérieure de la structure obtenue à l'issue de la suite d'étapes de la figure 1C. La couche 339 est une couche discontinue localisée au niveau des seuls pixels R et G du dispositif, et ne s'étend en particulier pas au-dessus des pixels B du dispositif. Plus particulièrement, la couche 339 comprend, au niveau de chaque pixel R, une portion 339R en contact électrique avec l'électrode inférieure 133 du pixel, et, au niveau de chaque pixel G, une portion 339G en contact électrique avec l'électrode inférieure 133 du pixel. Les couches 339R et 339G sont des couches actives de diode électroluminescente organique de natures distinctes. Plus particulièrement, chaque portion 339R est adaptée à émettre de la lumière dans une première gamme de longueurs d'ondes lorsqu'elle est traversée par un courant électrique, et chaque portion 339G est adaptée à émettre de la lumière dans une deuxième gamme de longueurs d'ondes distincte de la première gamme lorsqu'elle est traversée par un courant électrique. A titre d'exemple, la couche 339R est choisie adaptée à émettre uniquement de la lumière rouge, et la couche 339G est choisie adaptée à émettre uniquement de la lumière verte. Les couches localisées 339R et 339G sont par exemple déposées par sérigraphie ou à l'aide de pochoirs, ou par toute autre méthode de dépôt localisé d'une couche semiconductrice organique.

L'électrode supérieure 141 commune aux pixels R et G est ensuite déposée de façon similaire ou identique à ce qui a été décrit précédemment. En particulier, l'électrode 141 peut être une électrode continue s'étendant sur sensiblement toute la surface du dispositif, y compris au-dessus des pixels B. La couche d'encapsulation 143 peut ensuite être déposée de façon identique ou similaire à ce qui a été décrit précédemment, sur toute la surface supérieure du dispositif.

On notera que dans l'exemple de la figure 3, la couche semiconductrice organique 339 ne s'étendant pas au-dessus des pixels B du dispositif, l'électrode supérieure 131 des pixels B n'a pas besoin d'être isolée. Ainsi, la couche isolante localisée 137 peut être omise au moins au niveau des électrodes supérieures 131 des pixels B. Dans le cas où, comme cela est représenté sur la figure 3, l'électrode supérieure 141 des pixels R et G s'étend sur sensiblement toute la surface du dispositif, y compris au-dessus des pixels B, la face inférieure de l'électrode 141 vient alors directement en contact avec la face supérieure des électrodes 131, ce qui permet d'assurer l'interconnexion des électrodes supérieures de toutes les diodes du dispositif.

Du fait de la prévision des couches semiconductrices 339R et 339G spécifiquement adaptées aux longueurs d'ondes d'émission des pixels R et G respectivement, les filtres couleurs 145R, 145G surmontant les pixels R et G du dispositif de la figure 1D peuvent être omis dans le dispositif de la figure 3.

En pratique, le mode de réalisation de la figure 3 est bien adapté aux dispositifs d'affichage dans lesquels les pixels ont des dimensions importantes, par exemple dont la plus petite dimension en vue de dessus est supérieure à 20 µm et de préférence supérieure à 50 µm. Le mode de réalisation de la figure 1D est quant à lui bien adapté aux dispositifs d'affichage dans lesquels les pixels ont des dimensions relativement faibles, par exemple dont la plus petite dimension en vue de dessus est inférieure à 20 µm et de préférence inférieure à 5 µm, pour lesquels le dépôt localisé d'une couche semiconductrice organique serait difficile à réaliser.

Des modes de réalisation particuliers ont été décrits. Diverses variantes et modifications apparaîtront à l'homme de l'art. En particulier, on a décrit des exemples de réalisation dans lesquels, dans chaque pixel du dispositif, l'électrode inférieure de la diode du pixel est l'électrode d'anode et l'électrode supérieure de la diode du pixel est l'électrode de cathode. L'homme de l'art saura adapter les modes de réalisation en inversant la polarité des diodes du dispositif.

De plus, bien que l'on ait décrit uniquement des exemples de réalisation de dispositifs d'affichage comportant un type de pixel inorganique (les pixels B) et deux types de pixels organiques (les pixels R et G), les modes de réalisation décrits ne se limitent pas à ce cas particulier. A titre de variante, le dispositif d'affichage peut comporter plusieurs types de pixels inorganiques comportant chacun une diode électroluminescente au nitrure de gallium et adaptés à émettre dans des gammes de longueurs d'ondes distinctes. De plus, le dispositif d'affichage peut comporter un seul type de pixel organique, ou plus de deux types de pixels organiques adaptés à émettre dans des gammes de longueurs d'ondes distinctes.

## Revendications

1. Dispositif d'affichage monolithique comprenant :
une pluralité de premiers pixels (B) adaptés à émettre de la lumière dans une première gamme de longueurs d'ondes, et une pluralité de deuxièmes pixels (R, G) adaptés à émettre de la lumière dans une deuxième gamme de longueurs d'ondes, les premiers pixels (B) comportant chacun une diode électroluminescente au nitrure de gallium, et les deuxièmes pixels (R, G) comportant chacun une diode électroluminescente organique ; et
un circuit intégré de commande (110) comportant, du côté d'une face supérieure, pour chaque pixel (B, R, G), un plot métallique de connexion (113), les diodes électroluminescentes des premiers (B) et deuxièmes (R, G) pixels étant disposées du côté de la face supérieure du circuit de commande (110), et la diode électroluminescente de chaque pixel comportant une électrode inférieure (121, 133) connectée au plot métallique de connexion (113) du pixel,
dans lequel, dans chaque pixel (B, R, G), la diode électroluminescente du pixel comporte au moins une couche semiconductrice (123, 125, 127, 139 ; 339R, 339G) revêtant la face de la électrode inférieure (121, 133) opposée au circuit de commande (110), et une électrode supérieure (131, 141) revêtant la face de ladite au moins une couche semiconductrice opposée à la électrode inférieure, **caractérisé en ce que** les électrodes supérieures (131) des premiers pixels (B) et les électrodes inférieures (133) des deuxièmes pixels (R, G) sont disposées dans un même niveau conducteur (M) du dispositif.

2. Dispositif selon la revendication 1, dans lequel les électrodes supérieures (131 ; 141) des diodes électroluminescentes des premiers (B) et deuxièmes (R, G) pixels sont interconnectées.

3. Dispositif selon la revendication 1 ou 2, dans lequel ladite au moins une couche semiconductrice (139) des deuxièmes pixels (R, G) est une couche continue commune à tous les deuxièmes pixels (R, G) du dispositif et s'étendant sur sensiblement toute la surface du dispositif.

4. Dispositif selon la revendication 3, dans lequel, dans chaque premier pixel (B), la électrode supérieure (131) du pixel est isolée de ladite au moins une couche semiconductrice (139) des deuxièmes pixels (R, G) par une couche d'isolation localisée (137).

5. Dispositif selon la revendication 1 ou 2, dans lequel ladite au moins une couche semiconductrice (339R, 339G) des deuxièmes pixels (R, G) est une couche discontinue localisée au niveau des seules diodes électroluminescentes des deuxièmes pixels.

6. Procédé de fabrication d'un dispositif d'affichage monolithique comprenant une pluralité de premiers pixels (B) adaptés à émettre de la lumière dans une première gamme de longueurs d'ondes, et une pluralité de deuxièmes pixels (R, G) adaptés à émettre de la lumière dans une deuxième gamme de longueurs d'ondes, ce procédé comprenant les étapes successives suivantes :
a) former un circuit intégré de commande (110) comportant, sur une face supérieure, pour chaque pixel (B, R, G) du dispositif, un plot métallique de connexion (113) ;
b) pour chaque premier pixel (B), rapporter sur la face supérieure du circuit de commande (110) un empilement actif de diode électroluminescente au nitrure de gallium comportant une électrode inférieure (121) en contact avec le plot métallique de connexion (113) du pixel, et au moins une couche semiconductrice (123, 125, 127) revêtant la face de la électrode inférieure opposée au circuit de commande (110) ;
c) combler un volume séparant latéralement les empilements actifs des diodes électroluminescentes au nitrure de gallium par un matériau de remplissage isolant (129) ;
d) former, dans un même niveau conducteur (M), pour chaque premier pixel (B), une électrode supérieure (131) revêtant la face de ladite au moins une couche semiconductrice (123 ; 125 ; 127) opposée à la électrode inférieure, et, pour chaque deuxième pixel, une électrode inférieure (133) revêtant le matériau de remplissage (129) et connectée au plot métallique de connexion (113) du pixel.

7. Procédé selon la revendication 6, comportant en outre, après l'étape d), une étape e) de dépôt, pour chaque deuxième pixel (R, G), d'au moins une couche semiconductrice organique (139 ; 339R, 339G) revêtant la face de la électrode inférieure (133) du pixel opposée au circuit de commande (110).

8. Procédé selon la revendication 7, dans lequel ladite au moins une couche semiconductrice organique (139) est une couche continue commune à tous les deuxièmes pixels (R, G) du dispositif et s'étendant sur sensiblement toute la surface du dispositif.

9. Procédé selon la revendication 8, comportant en outre, entre l'étape d) et l'étape e), une étape de formation d'une couche d'isolation localisée (137) isolant les électrodes supérieures (131) des premiers pixels (B) de ladite au moins une couche semiconductrice organique (139).

10. Procédé selon la revendication 7, dans lequel ladite au moins une couche semiconductrice organique (339R, 339G) est une couche discontinue localisée au niveau des seules diodes électroluminescentes des deuxièmes pixels (R, G).

11. Procédé selon l'une quelconque des revendications 7 à 10, comportant en outre, après l'étape e), une étape de dépôt, pour chaque deuxième pixel, d'une électrode supérieure (141) revêtant la face de ladite au moins une couche semiconductrice organique (139 ; 339R, 339G) opposée à la électrode inférieure (133) du pixel.

12. Procédé selon la revendication 11, dans lequel les électrodes supérieures (141) des deuxièmes pixels (R, G) forment une couche continue s'étendant sur sensiblement toute la surface du dispositif.

## Patentansprüche

1. Eine monolithische Anzeigevorrichtung, die Folgendes aufweist:
eine Vielzahl von ersten Pixeln (B), die in der Lage sind, Licht in einem ersten Wellenlängenbereich zu emittieren, und eine Vielzahl von zweiten Pixeln (R, G), die in der Lage sind, Licht in einem zweiten Wellenlängenbereich zu emittieren, wobei die ersten Pixel (B) jeweils eine Galliumnitrid-Leuchtdiode aufweisen und die zweiten Pixel (R, G) jeweils eine organische Leuchtdiode aufweisen; und
eine integrierte Steuerschaltung (110), die auf der Seite einer oberen Fläche für jedes Pixel (B, R, G) eine metallische Anschlussfläche (113) aufweist, wobei die Leuchtdioden der ersten (B) und zweiten (R, G) Pixel auf der Seite der oberen Fläche der Steuerschaltung (110) angeordnet sind und die Leuchtdiode jedes Pixels eine untere Elektrode (121, 133) aufweist, die mit der metallischen Anschlussfläche (113) des Pixels verbunden ist,
wobei in jedem Pixel (B, R, G) die lichtemittierende Diode des Pixels mindestens eine Halbleiterschicht bzw. -ebene (123, 125, 127, 139; 339R, 339G) aufweist, die die Oberfläche der unteren Elektrode (121, 133) gegenüber der Steuerschaltung (110) bedeckt bzw. überzieht, und eine obere Elektrode (131, 141), die die Oberfläche der mindestens einen Halbleiterschicht gegenüber der unteren Elektrode bedeckt, **dadurch gekennzeichnet, dass** die oberen Elektroden (131) der ersten Pixel (B) und die unteren Elektroden (133) der zweiten Pixel (R, G) in derselben Leiterebene (M) der Vorrichtung angeordnet sind.

2. Vorrichtung nach Anspruch 1, wobei die oberen Elektroden (131; 141) der Leuchtdioden der ersten (B) und zweiten (R, G) Pixel miteinander verbunden sind.

3. Vorrichtung nach Anspruch 1 oder 2, wobei die mindestens eine Halbleiterschicht (139) der zweiten Pixel (R, G) eine kontinuierliche Schicht ist, die allen zweiten Pixeln (R, G) der Vorrichtung gemeinsam ist und sich im Wesentlichen über die gesamte Oberfläche der Vorrichtung erstreckt.

4. Vorrichtung nach Anspruch 3, wobei in jedem ersten Pixel (B) die obere Elektrode (131) des Pixels von der mindestens einen Halbleiterschicht (139) der zweiten Pixel (R, G) durch eine lokale Isolierschicht (137) isoliert ist.

5. Vorrichtung nach Anspruch 1 oder 2, wobei die mindestens eine Halbleiterschicht (339R, 339G) der zweiten Pixel (R, G) eine diskontinuierliche Schicht ist, die sich nur auf der Ebene der lichtemittierenden Dioden der zweiten Pixel befindet.

6. Ein Verfahren zur Herstellung einer monolithischen Anzeigevorrichtung mit einer Vielzahl von ersten Pixeln (B), die in der Lage sind, Licht in einem ersten Wellenlängenbereich zu emittieren, und einer Vielzahl von zweiten Pixeln (R, G), die in der Lage sind, Licht in einem zweiten Wellenlängenbereich zu emittieren, wobei das Verfahren die folgenden aufeinanderfolgenden Schritte aufweist:
a) Bilden einer integrierten Steuerschaltung (110), die auf einer oberen Fläche für jedes Pixel (B, R, G) der Vorrichtung eine metallische Anschlussfläche (113) aufweist;
b) für jedes erste Pixel (B) Anordnen eines Stapels aktiver Galliumnitrid-Leuchtdioden auf der oberen Oberfläche der Steuerschaltung (110), der eine untere Elektrode (121) in Kontakt mit dem metallischen Verbindungspad (113) des Pixels und mindestens eine Halbleiterschicht bzw. -ebene (123, 125, 127) aufweist, die die Oberfläche der unteren Elektrode gegenüber der Steuerschaltung (110) bedeckt;
c) Füllen eines Volumens, das die aktiven Stapel der Galliumnitrid-Leuchtdioden seitlich trennt, mit einem isolierenden Füllmaterial (129);
d) Bilden in einer gleichen Leiterebene (M) für jedes erste Pixel (B) eine obere Elektrode (131), die die Oberfläche der mindestens einen Halbleiterschicht (123; 125; 127) gegenüber der unteren Elektrode überzieht bzw. bedeckt, und für jedes zweite Pixel eine untere Elektrode (133), die das Füllmaterial (129) überzieht und mit der metallischen Anschlussfläche (113) des Pixels verbunden ist.

7. Verfahren nach Anspruch 6, das ferner nach Schritt d), einen Schritt e) der Abscheidung, für jedes zweite Pixel (R; G), von mindestens einer organischen Halbleiterschicht (139; 339R, 339G), die die Oberfläche der unteren Elektrode (133) des Pixels gegenüber der Steuerschaltung (110) bedeckt, aufweist.

8. Verfahren nach Anspruch 7, wobei die mindestens eine organische Halbleiterschicht (139) eine kontinuierliche Schicht ist, die allen zweiten Pixeln (R, G) der Vorrichtung gemeinsam ist und sich im Wesentlichen über die gesamte Oberfläche der Vorrichtung erstreckt.

9. Verfahren nach Anspruch 8, das ferner zwischen Schritt d) und Schritt e) einen Schritt des Bildens einer lokalen Isolationsschicht (137), die die oberen Elektroden (131) der ersten Pixel (B) von der mindestens einen organischen Halbleiterschicht (139) isoliert, aufweist.

10. Verfahren nach Anspruch 7, wobei die mindestens eine organische Halbleiterschicht (339R, 339G) eine diskontinuierliche Schicht ist, die sich nur auf der Ebene der lichtemittierenden Dioden der zweiten Pixel (R, G) befindet.

11. Verfahren nach einem der Ansprüche 7 bis 10, das ferner, nach Schritt e), einen Schritt der Abscheidung, für jedes Pixel, einer oberen Elektrode (141), die die Oberfläche der mindestens einen organischen Halbleiterschicht (139; 339R, 339G) gegenüber der unteren Elektrode (133) des Pixels bedeckt, aufweist.

12. Verfahren nach Anspruch 11, wobei die oberen Elektroden (141) der zweiten Pixel (R, G) eine kontinuierliche Schicht bilden, die sich im Wesentlichen über die gesamte Oberfläche der Vorrichtung erstreckt.

## Claims

1. A monolithic display device comprising:
a plurality of first pixels (B) capable of emitting light in a first wavelength range, and a plurality of second pixels (R, G) capable of emitting light in a second wavelength range, the first pixels (B) each comprising a gallium nitride light-emitting diode, and the second pixels (R, G) each comprising an organic light-emitting diode; and
an integrated control circuit (110) comprising, on the side of an upper surface, for each pixel (B, R, G), a metal connection pad (113), the light-emitting diodes of the first (B) and second (R, G) pixels being arranged on the side of the upper surface of the control circuit (110), and the light-emitting diode of each pixel comprising a lower electrode (121, 133) connected to the metal connection pad (113) of the pixel,
wherein, in each pixel (B, R, G), the light-emitting diode of the pixel comprises at least one semiconductor layer (123, 125, 127, 139; 339R, 339G) coating the surface of the lower electrode (121, 133) opposite to the control circuit (110), and an upper electrode (131, 141) coating the surface of said at least one semiconductor layer opposite to the lower electrode, **characterized in that** the upper electrodes (131) of the first pixels (B) and the lower electrodes (133) of the second pixels (R, G) are arranged in a same conductor level (M) of the device.

2. The device of claim 1, wherein the upper electrodes (131; 141) of the light-emitting diodes of the first (B) and second (R, G) pixels are interconnected.

3. The device of claim 1 or 2, wherein said at least one semiconductor layer (139) of the second pixels (R, G) is a continuous layer common to all the second pixels (R, G) of the device and extending over substantially the entire surface of the device.

4. The device of claim 3, wherein, in each first pixel (B), the upper electrode (131) of the pixel is insulated from said at least one semiconductor layer (139) of the second pixels (R, G) by a local insulation layer (137).

5. The device of claim 1 or 2, wherein said at least one semiconductor layer (339R, 339G) of the second pixels (R, G) is a discontinuous layer located at the level of the light-emitting diodes of the second pixels only.

6. A method of manufacturing a monolithic display device comprising a plurality of first pixels (B) capable of emitting light in a first wavelength range and a plurality of second pixels (R, G) capable of emitting light in a second wavelength range, the method comprising the successive steps of:
a) forming an integrated control circuit (110) comprising, on an upper surface, for each pixel (B, R, G) of the device, a metal connection pad (113);
b) for each first pixel (B), placing on the upper surface of the control circuit (110) an active gallium nitride light-emitting diode stack comprising a lower electrode (121) in contact with the metal connection pad (113) of the pixel, and at least one semiconductor layer (123, 125, 127) coating the surface of the lower electrode opposite to the control circuit (110);
c) filling a volume laterally separating the active stacks of the gallium nitride light-emitting diodes with an insulating filling material (129);
d) forming, in a same conductor level (M), for each first pixel (B), an upper electrode (131) coating the surface of said at least one semiconductor layer (123; 125; 127) opposite to the lower electrode and, for each second pixel, a lower electrode (133) coating the filling material (129) and connected to the metal connection pad (113) of the pixel.

7. The method of claim 6, further comprising, after step d), a step e) of deposition, for each second pixel (R; G), of at least organic semiconductor layer (139; 339R, 339G) coating the surface of the lower electrode (133) of the pixel opposite to the control circuit (110).

8. The method of claim 7, wherein said at least one organic semiconductor layer (139) is a continuous layer common to all the second pixels (R, G) of the device and extending over substantially the entire surface of the device.

9. The method of claim 8, further comprising, between step d) and step e), a step of forming a local insulation layer (137) insulating the upper electrodes (131) of the first pixels (B) from said at least one organic semiconductor layer (139).

10. The method of claim 7, wherein said at least one organic semiconductor layer (339R, 339G) is a discontinuous layer located at the level of the light-emitting diodes of the second pixels (R, G) only.

11. The method of any of claims 7 to 10, further comprising, after step e), a step of deposition, for each pixel, of an upper electrode (141) coating the surface of said at least one organic semiconductor layer (139; 339R, 339G) opposite to the lower electrode (133) of the pixel.

12. The method of claim 11, wherein the upper electrodes (141) of the second pixels (R, G) form a continuous layer extending over substantially the entire surface of the device.
